# EUROPEAN PATENT APPLICATION

(11) **EP 4 332 187 A1**
(43) Date of publication of application: **06.03.2024**
(21) Application number: 22795820.4
(22) Date of filing: 26.04.2022
(51) Int. Cl.: C09J 7/20, C09J 201/00, H01L 21/301, C09J 7/25

(54) **TAPE**

(30) Priority: 28.04.2021 JP 2021076510
(71) Applicant: Fujimori Kogyo Co., Ltd., Tokyo 112-0002 (JP)
(72) Inventor: SUZUKI, Yuna, Tokyo 112-0002 (JP); TSUKUDA, Souichi, Tokyo 112-0002 (JP); CHISHIMA, Kenji, Tokyo 112-0002 (JP)
(74) Representative: Lavoix
(86) International application number: PCT/JP2022/018955
(87) International publication number: WO 2022/230907

(57) **Abstract**

This tape (10) has a substrate layer (12) and a pressure-sensitive adhesive layer (11) on one surface of the substrate layer (12), and has an elongation at break of 100% or more and an elastic modulus of 2 GPa or less. The tape (10) has, after having heated at 230°C for 80 seconds, an elongation at break of 100% or more and the elastic modulus of 2 GPa or less.

## Description

### TECHNICAL FIELD

The present invention relates to a tape.

Priority is claimed on Japanese Patent Application No. 2021-076510, filed April 28, 2021, the content of which is incorporated herein by reference.

### BACKGROUND ART

In a manufacturing process of semiconductor parts, as disclosed in Patent Documents 1 to 4, a tape with an adhesive layer is used to attach a semiconductor to be machined.

### CITATION LIST

### [Patent Document]

[Patent Document 1]
   Japanese Unexamined Patent Application, First Publication No. 2003-105292
[Patent Document 2]
   Japanese Unexamined Patent Application, First Publication No. 2010-225753
[Patent Document 3]
   Japanese Unexamined Patent Application, First Publication No. 2010-251722
[Patent Document 4]
   PCT International Publication No. 2017/154619

### SUMMARY OF INVENTION

### Technical Problem

When a semiconductor fixed to a tape is a chip, tracking performance of the tape is required for the chip. The tracking performance means that the tape is applied to the chip having a 3-dimensional shape with appropriate extension and almost no gap. In addition, when the semiconductor chip fixed to the tape is mounted on a substrate such as an interposer or the like, in a reflow process, the tape must have thermal resistance to withstand a melting temperature of a solder.

In consideration of the above-mentioned circumstances, the present invention is directed to provide a tape having tracking performance and thermal resistance.

### Solution to Problem

In order to achieve the aforementioned objects, a tape of an aspect of the present invention is a tape having a pressure-sensitive adhesive layer on one surface of a substrate layer, the tape has an elongation at break of 100% or more and an elastic modulus of 2 GPa or less, and even after having been heated at 230°C for 80 seconds, the tape has an elongation at break of 100% or more and the elastic modulus of 2 GPa or less.

In the tape, an adhesive force may be able to be decreased by curing the pressure-sensitive adhesive layer.

The tape is a tape having the pressure-sensitive adhesive layer on one surface of the substrate layer formed using solvent soluble polyimde varnish, and the adhesive force may be able to be decreased by curing the pressure-sensitive adhesive layer.

The tape may be a tape having the pressure-sensitive adhesive layer on one surface of the substrate layer having a high extension polyimide resin, which has an aliphatic unit with a number of carbon atoms of three or more between aromatic units, and the adhesive force may be able to be decreased by curing the pressure-sensitive adhesive layer. The high extension characteristics mean that the material has low elastic modulus and sufficient pulling stretchability, such as a polyethylene film or a polypropylene film, and can be easily stretched by hand.

The tape may be configured so that the adhesive force against a flat surface of polybenzoxazole (PBO) at room temperature is 0.5 N/25 mm or less after having heated at 230°C for 80 seconds or after the adhesive force is decreased due to curing of the pressure-sensitive adhesive layer.

The tape may have a release film provided on a pressure-sensitive adhesive surface of the pressure-sensitive adhesive layer opposite to the substrate layer.

The tape may be a protective tape for a semiconductor chip.

### ADVANTAGEOUS EFFECTS OF INVENTION

According to the tape of the present invention, the elongation at break is 100% or more and the elastic modulus is 2 GPa or less, and even after having been heated at 230°C for 80 seconds, the elongation at break of 100% or more and the elastic modulus of 2 GPa or less are maintained, and thus, even when the tape holds the semiconductor chip, tracking performance and thermal resistance are provided.

### BRIEF DESCRIPTION OF DRAWINGS

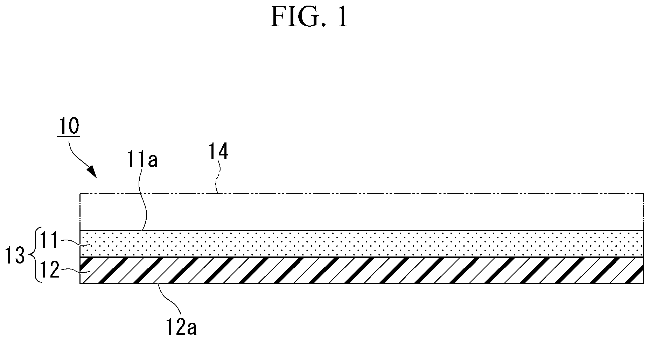

FIG. 1 is a cross-sectional view showing an embodiment of a tape according to the present invention.

### DESCRIPTION OF EMBODIMENTS

Hereinafter, the present invention will be described on the basis of an appropriate embodiment. FIG. 1 shows an example of a tape of the embodiment of the present invention. A tape 10 of the embodiment is provided with a substrate layer 12 and a pressure-sensitive adhesive layer 11 on one surface of a substrate layer 12, and has an elongation at break of 100% or more and an elastic modulus of 2 GPa or less. A specific measurement method of the elongation at break and the elastic modulus is disclosed in an example, which will be described below. Further, the tape 10 holds the elongation at break of 100% or more and the elastic modulus of 2 GPa or less even after having been heated at 230°C for 80 seconds.

An upper limit of the elongation at break before and after heating is not particularly limited in the present invention, but may be about 200% as an industrially preferable range. In addition, a lower limit of the elastic modulus before and after heating is not particular limited in the present invention, but may be about 1 GPa as an industrially preferable range.

The pressure-sensitive adhesive layer 11 can fix an adherend such as a semiconductor wafer, a semiconductor chip, or the like, with a predetermined adhesive force. The adherend is fixed to a pressure-sensitive adhesive surface 11a of the pressure-sensitive adhesive layer 11. In the specification, the pressure-sensitive adhesive layer refers to either a pressure-sensitive adhesive layer, an adhesive layer, or a layer having both properties of a pressure-sensitive adhesive layer and an adhesive layer. The pressure-sensitive adhesive layer 11 can be formed of a pressure-sensitive adhesive agent. The pressure-sensitive adhesive agent refers to either a pressure-sensitive adhesive agent, an adhesive agent, or a layer having both properties of a pressure-sensitive adhesive agent and an adhesive agent. The adhesive force is a peel strength, and for example, refers to a pressure-sensitive adhesive force (tack strength) or an adhesive force. The pressure-sensitive adhesive surface 11a is the surface on which the pressure-sensitive adhesive layer 11 has an adhesive force, and for example, refers to a pressure-sensitive adhesive surface (sticky surface) or an adhesive surface.

As a specific example of the pressure-sensitive adhesive agent, an acryl-based pressure-sensitive adhesive agent, a silicon-based pressure-sensitive adhesive agent, a urethane-based pressure-sensitive adhesive agent, an epoxy-based adhesive agent, an olefin-based heat sealing agent, or the like, is exemplified. The pressure-sensitive adhesive layer 11 is not limited to the pressure sensitive adhesive agent (pressure-sensitive adhesive agent) and may be formed using a curing type adhesive agent, a reaction type adhesive agent, a solvent type adhesive agent, or the like. The tape 10 that uses a pressure-sensitive adhesive agent on the pressure-sensitive adhesive layer 11 may be a pressure-sensitive adhesive tape. The tape 10 that uses an adhesive agent on the pressure-sensitive adhesive layer 11 may be an adhesive tape.

As long as the adherend is not adhered to the pressure-sensitive adhesive layer 11, the tape 10 may have a release film 14 attached to the pressure-sensitive adhesive surface 11a of the pressure-sensitive adhesive layer 11.

In order to improve a bonding force between the pressure-sensitive adhesive layer 11 and the substrate layer 12, the substrate layer 12 may have an anchoring agent layer between the substrate layer 12 and the pressure-sensitive adhesive layer 11. The anchoring agent layer is a layer formed of a material that is adhered to both the substrate layer 12 and the pressure-sensitive adhesive layer 11 in order to increase the bonding force therebetween. A thickness of the anchoring agent layer is not particularly limited but may be, for example, about 1 and 20 µm.

When the tape 10 has the release film 14, the release film 14 is removed before applying the tape 10 to the adherend. A tape main body 13 having the pressure-sensitive adhesive layer 11 on one surface of the substrate layer 12 is bonded to the adherend.

As the substrate layer 12, while not particularly limited, one resin, a mixture or a copolymer of two or more resins, selected from a polyolefin resin such as a polyethylene (PE) resin, a polypropylene (PP) resin, or the like; a polyester resin such as a polyethylene terephthalate (PET) resin, a polybutylene terephthalate (PBT) resin, a polyethylene naphthalate (PEN) resin, or the like; a polyamide (PA) resin such as Nylon or the like, a polyimide (PI) resin, a polyetherimide (PEI) resin, a polyamideimide (PAI) resin, a polycarbonate (PC) resin, a polyethersulfone (PES) resin, a polyphenylene sulfide (PPS) resin, a polyethereketone (PEEK) resin, a fluorine resin, and the like, is exemplified.

Optical characteristics of the substrate layer 12 are not particularly limited, and it can be used regardless of whether it is transparent, translucent or opaque. The substrate layer 12 may be a colored or printed resin film. A thickness of the substrate layer 12 is not particularly limited, but for example, 5 to 500 µm is exemplified, and in the case of a thin film type, it may be about 15 to 30 µm. The substrate layer 12 may be a single layer or may be a laminated body of two layers or more.

From the viewpoint of the tracking performance or the like with respect to the adherend, it is preferable that the elongation at break of the tape 10 be 100% or more and the elastic modulus of the tape 10 be 2 GPa or less. When the tape 10 has the release film 14, as the elongation at break and the elastic modulus of the embodiment, an elongation at break and an elastic modulus of the tape main body 13 having the pressure-sensitive adhesive layer 11 on one surface of the substrate layer 12 except the release film 14 are measured.

The elongation at break is a value expressed in % when a specimen such as a film or the like is fractured by constant speed pulling. Specifically, when a length of a specimen before a tensile test is Lo and a length of the specimen after fracture is L, the elongation at break is represented as (L-Lo)/Lo×100 (%). As the elongation at break is increased, flexibility of a film against a tensile force is increased. A specific example of a measurement condition of the elongation at break is disclosed as an example described below.

The elastic modulus is a constant of proportionality between stress and distortion when a specimen such as a film or the like is elastically deformed. As the elastic modulus, a tensile elastic modulus, a compressive elastic modulus, a bending elastic modulus, a shearing elastic modulus, a torsion elastic modulus, or the like, is exemplified. An elastic modulus in a tensile direction is referred to as a Young's modulus. An apparatus and a specimen used in a test of the Young's modulus are the same as in the test of the elongation at break. The elastic modulus of the tape 10 is not particularly limited as long as it is 2 GPa or less, but may be 0.5 GPa or more, for example, about 1.0 GPa. A specific example of the measurement condition of the elastic modulus is disclosed as an example described below. A lower limit of the elastic modulus of the tape 10 is not particularly limited in the present invention, but may be about 0.5 GPa.

The substrate layer 12 preferably has a thermal resistance against heating treatment at a heating temperature of, for example, 200°C to 260°C as a resin with high thermal resistance. Having thermal resistance means that (no pyrolysis or deformation occurs) when the substrate layer 12 is heated to the temperature range. As a specific example of the thermal resistant resin, for example, one resin, a mixture of two resins or more of polyimide (PI) resin, a polyeterimide (PEI) resin, a polyamideimide (PAI) resin, a polyetersulfone (PES) resin, a polyphenylene sulfide (PPS) resin, a polyethereketone (PEEK) resin, a polyethylene naphthalate (PEN) resin, a fluorine resin, and the like, or a copolymer is exemplified.

When the tape 10 is used for heating treatment, the above-mentioned elongation at break and elastic modulus are preferably maintained even after the heating treatment. For example, even after the tape 10 is heated at 230°C for 80 seconds, it is preferable to hold an elongation at break of 100% or more and an elastic modulus of 2 GPa or less.

In at least one of the substrate layer 12, as the resin having both the thermal resistance and the flexibility, for example, a high extension polyimide resin having an aliphatic unit with a carbon number of 3 or more between aromatic units is preferably used. Further, the aliphatic unit preferably includes a polyalkyleneoxy group having an alkylene group with a carbon number of about 1 to 10. As a material for forming the polyimide resin layer, solvent soluble polyimide varnish may be used. The polyimide resin may be copolymer having an imide group in a molecule, or may be a polyeterimide (PEI) resin, a polyamideimide (PAI) resin, or the like.

The pressure-sensitive adhesive layer 11 can preferably decrease an adhesive force against the adherend such that the adherend such as a semiconductor wafer, a semiconductor chip, or the like, can be removed according to necessity. For example, by adding the photosensitive material such as a photocurable resin, a photoinitiator, or the like, to the pressure-sensitive adhesive layer 11, the pressure-sensitive adhesive layer 11 can be cured when it is irradiated with energy beams such as ultraviolet rays, electron beams, or the like, and the adhesive force can be decreased. In this case, the substrate layer is preferably permeable to the energy beam for curing the pressure-sensitive adhesive layer 11. For example, preferably, the substrate layer 12 has a transmissivity of 15% or more at wavelengths of 365 nm, 405 nm, or therebetween. More preferably, the transmissivity is 50% or more.

The release film 14 is not particularly limited as long as it is a film that can be peeled and removed before the film covers the pressure-sensitive adhesive layer 11 not in use of the tape 10 to protect the pressure-sensitive adhesive layer 11 and fix the adherend. The release film 14 may be a resin film having a release agent layer constituted by, for example, a silicon-based release agent, a fluorine-based release agent, a long-chain alkyl-based release agent, and the like, on a surface thereof, or may be a resin film with no release agent layer on a surface thereof. The release film 14 does not need to have excellent thermal resistance, high extension characteristics, energy beam permeability, etc., but may have transparency to facilitate visual inspection of the pressure-sensitive adhesive layer 11.

The method of manufacturing the tape 10 is not particularly limited, but the tape 10 may be manufactured by forming the pressure-sensitive adhesive layer 11 on the substrate layer 12. After the pressure-sensitive adhesive layer 11 is formed on the release film 14, the tape 10 may be manufactured by compounding the substrate layer 12. The tape 10 may be manufactured by sequentially forming, such as by coating, the pressure-sensitive adhesive layer 11 and the substrate layer 12 on the release film 14.

When the tape 10 is wound in a roll shape, a laminated body having the tape main body 13 and the release film 14 may have a roll shape. In addition, the release film 14 may be omitted and the pressure-sensitive adhesive layer 11 of the tape main body 13 may be wound to overlap the substrate layer 12. When the release film 14 is omitted, the substrate layer 12 may also serve as the release film 14, and a release agent layer may be provided on the back surface 12a of the substrate layer 12.

While the method of manufacturing semiconductor parts using the tape 10 is not particularly limited, the tape 10 may be attached to a semiconductor wafer or the tape 10 may be attached to a semiconductor chip. When the tape 10 is used upon machining of the semiconductor wafer, a manufacturing method having a fixing process of fixing a semiconductor wafer to the pressure-sensitive adhesive layer 11 of the tape 10, a dicing process of cutting the semiconductor wafer to which the tape 10 is attached and obtaining a semiconductor chip on the pressure-sensitive adhesive layer 11, and a pickup process of peeling the semiconductor chip from the tape 10 is exemplified. When the tape 10 is used to protect the semiconductor chip, the semiconductor chip obtained by cutting the semiconductor wafer may be fixed to the pressure-sensitive adhesive layer 11 of the tape 10 and machining or the like of the semiconductor chip may be performed on the tape 10.

Each process for the manufacture of semiconductor parts may be carried out in a situation where the entity, location, or the like performing each process is different from the fixing process. When the adherend is removed from the pressure-sensitive adhesive layer 11, the pressure-sensitive adhesive layer 11 may be irradiated with energy beams to decrease an adhesive force of the pressure-sensitive adhesive layer 11. In a state in which the semiconductor chip is fixed on the pressure-sensitive adhesive layer 11, a reflow process may be performed to solder the semiconductor chip with other components such as an interposer, a lead frame, or the like. When the tape 10 is applied to the reflow process, the tape 10 preferably has a thermal resistance to withstand the reflow process. The solder used in the reflow is not particularly limited, but for example, may have a plate shape, a paste shape, a cream shape, or the like. The tape 10 may be used to temporarily fix the semiconductor chip before reflow to the interposer or the like. In order to closely attach the tape 10 to the semiconductor chip or the like, the surrounding area may be suctioned with a vacuum.

Hereinabove, while the present invention has been described on the basis of the appropriate embodiment, the present invention is not limited to the above-mentioned embodiment and various modifications may be made without departing from the spirit of the present invention.

The adherend is not limited to semiconductor wafers and semiconductor chips such as silicon (Si) or the like, but includes glass substrates, metal substrates, resin substrates, laminated bodies containing one or more of these, electronic equipment, and the like. Even in these adherend, in the same manner as the manufacturing method of the semiconductor parts described above, after the process of performing machining, processing, or the like of the adherend to which the tape is attached, the process of peeling off the adherend from the tape 10 can be performed. Applications of the tape are not particularly limited, but include a protective tape, a cover tape, a dicing tape, a die bonding tape, a masking tape, a sanding tape, a sealing tape, a conveyance tape, an insulating tape, a process tape, and the like.

### EXAMPLES

Hereinafter, the present invention will be specifically described with examples.

### [Fabrication of Tape of Examples 1 and 2]

Tapes of Examples 1 and 2 were fabricated by forming pressure-sensitive adhesive layers of a thickness of 20 µm using a pressure-sensitive adhesive agent of a micro pressure-sensitive adhesive having a thermal resistance and forming a substrate layer using a solvent soluble polyimde varnish (Product name: MP17A) manufactured by Mitsui Chemicals Inc. In the tape of Example 1, the thickness of the substrate layer was 12.5 µm. In the tape of Example 2, the thickness of the substrate layer was 25 µm.

### [Fabrication of Tape of Comparative Example 1]

A tape of Comparative Example 1 was fabricated by forming a pressure-sensitive adhesive layer with a thickness of 20 µm using the same material as Example 1 and 2 and forming a substrate layer using a polyethereketone film (Product name: EXPEEK (trade mark), a thickness of 25 µm) manufactured by Kurabo Industries, Ltd.

### [Fabrication of Tape of Comparative Example 2]

A tape of Comparative Example 2 was fabricated by forming a pressure-sensitive adhesive layer with a thickness of 20 µm using the same material as Examples 1 and 2 and forming a substrate layer using a polyimide film (product name: Kapton (trade mark) 50H, a thickness of 12.5 µm) of Toray Du Pont Ltd.

### [Estimation of tracking performance]

A vacuum tape mounter was used to bond the tape onto an interposer on which a chip with a height of 50 to 60 µm was placed at intervals of 500 to 600 µm. The tape was bonded to a surface of the interposer and an outer circumference surface of each chip to cover surroundings of a plurality of chips disposed on the interposer. A case in which the tape was deformed to follow a 3-dimensional shape of each chip with substantially no gap was estimated as (∘), and a case in which the tape was not deformed to follow each chip was estimated as (×).

### [Estimation of tensile characteristics]

Three types of a Young's modulus, fracture strength, and an elongation at break were measured as tensile characteristics. A tensile test machine (Product name: AGS-X 500N) manufactured by Shimadzu Corporation was used for a measurement device. A size of the specimen was a width of 15 mm and a length of 120 mm. An environment temperature was set as a room temperature (23°C), both ends of the specimen in a lengthwise direction were clamped by 10 mm each by clamping jaws of the tensile test machine, tensile tests were repeated three times at a tension rate of 50mm/min, and the average values of three times were calculated for each of the properties below.

The Young's modulus (GPa) was obtained from an initial slope of the stress and distortion chart in the tensile test.

The fracture strength was a strength (MPa) measured when the specimen was fractured.

The elongation at break was calculated by setting a length of the specimen before the tensile test as Lo, a length of the specimen upon fracture as L, and a tensile elongation (%) when the specimen was fractured as 100×(L-Lo)/Lo.

### [Thermal resistance]

For thermal resistance, with respect to the specimen after the same type of specimen as the above-mentioned tensile characteristics was placed in an oven, heated in air at 230°C for 80 seconds, and then cooled to a room temperature (23°C), three types of a Young's modulus, a fracture strength, and an elongation at break were measured as tensile characteristics under the same condition, and an average value of each of the three test results was obtained.

### [Adhesive force]

The adhesive force was repeatedly measured three times and an average value was employed under a condition in which a tensile test machine (Product name: EZ Graph) manufactured by Shimadzu Corporation was used, a size of a specimen was a width of 25 mm and a length of 100 mm, a temperature was 23°C (room temperature), an adherend was a PBO processing silicon wafer, a bonding method was performed using a 2kg roller, an adhering region was a width of 25 mm and a length of 9 0mm, a tension rate was 300 mm/min, and a peeling angle was 180°. Two types of "an initial adhesive force" and "an adhesive force after heating" were measured as the adhesive force. The "initial adhesive force" is an adhesive force measured before heating. The "adhesive force after heating" is an adhesive force measured after heating in air at 230°C for 80 seconds. The PBO processing silicon wafer of the adherend is a silicon wafer having a PBO film on a surface, and the adhesive force against a flat surface of the PBO is measured using the adherend.

Estimation results are shown in Table 1.

**TABLE 1**

| | | Example 1 | Example 2 | Comparative example 1 | Comparative example 2 |
|---|---|---|---|---|---|
| Substrate layer | Thickness (µm) | 12.5 | 25 | 25 | 12.5 |
| Pressure-sensitive adhesive layer | Thickness (µm) | 20 | 20 | 20 | 20 |
| Tracking performance | | ○ | ○ | × | × |
| Tensile characteristics | Young's modulus (GPa) | 0.8 | 1.0 | 3.0 | 3.5 |
| | Fracture strength (MPa) | 42.0 | 32.0 | 133.0 | 355.0 |
| | Elongation at break (%) | 122.0 | 128.0 | 93.0 | 80.0 |
| Thermal resistance | Young's modulus (GPa) | 1.2 | 1.0 | 2.8 | 3.2 |
| | Fracture strength (MPa) | 43.0 | 51.0 | 152.0 | 368.0 |
| | Elongation at break (%) | 118.0 | 116.0 | 85.0 | 82.0 |
| Initial adhesive force (N/25 mm) | | 0.3 | 0.3 | 0.3 | 0.3 |
| Adhesive force after heating (N/25 mm) | | 0.23 | 0.23 | 0.23 | 0.23 |

The tapes of Examples 1 and 2 had the thermal resistance that could withstand the reflow process, and the tracking performance and the adhesive force against the chip. It was found that, due to the high elongation at break and low elastic modulus of the tape, even for the adherend with irregularities on the surface to be adhered, such as a substrate on which circuit parts such as semiconductor chips or the like were arranged, excellent tracking performance could be achieved for the surface to be adhered included around the irregularities.

In the tapes of Comparative Examples 1 and 2, the elongation at break was less than 100%, the elastic modulus exceeded 2 GPa, and the tracking performance against the chip was deteriorated. The tapes of Comparative Examples 1 and 2 also had thermal resistance in that there was not much difference between the tensile characteristics before heating and the tensile characteristics after heating at 230°C for 80 seconds. Although the tape had thermal resistance, the tracking performance against the chip was inferior because the elongation at break was low and the elastic modulus (Young's modulus) was high, so the deformation characteristics of the tape were low.

### REFERENCE SIGNS LIST

| | | | |
|---|---|---|---|
| 10: | Tape | 11: | Pressure-sensitive adhesive layer |
| 11a: | Pressure-sensitive adhesive surface | 12: | Substrate layer |
| 12a: | Back surface | 13: | Tape main body |
| 14: | Release film | | |

## Claims

1. A tape comprising a substrate layer and a pressure-sensitive adhesive layer on one surface of the substrate layer, wherein the tape has an elongation at break of 100% or more and an elastic modulus of 2 GPa or less, and the tape has, after having been heated at 230°C for 80 seconds, an elongation at break of 100% or more and an elastic modulus of 2 GPa or less.

2. The tape according to claim 1, wherein the pressure-sensitive adhesive layer is configured so that an adhesive force of the pressure-sensitive adhesive layer can be decreased by curing the pressure-sensitive adhesive layer.

3. The tape according to claim 1 or 2, wherein an adhesive force of the pressure-sensitive adhesive layer against polybenzoxazole (PBO) is 0.5 N/25 mm or less after having been heated at 230°C for 80 seconds or after the adhesive force is decreased due to curing of the pressure-sensitive adhesive layer.

4. The tape according to claim 1 or 2, wherein a release film is provided on a pressure-sensitive adhesive surface of the pressure-sensitive adhesive layer opposite to the substrate layer.

5. The tape according to claim 1 or 2, wherein the tape is a protective tape for a semiconductor chip.
